# EUROPEAN PATENT SPECIFICATION

(11) **EP 2 543 061 B1**
(45) Date of publication and mention of the grant of the patent: **21.11.2018**
(21) Application number: 11750245.0
(22) Date of filing: 07.03.2011
(51) Int. Cl.: G06F 3/041, G06F 3/044, B82B 1/00

(54) **A METHOD FOR THE PRODUCTION OF A CONFORMAL ELEMENT, A CONFORMAL ELEMENT AND USES OF THE SAME**
VERFAHREN ZUR HERSTELLUNG EINES KONFORMEN ELEMENTS, KONFORMES ELEMENT UND VERWENDUNG DAVON
PROCÉDÉ DESTINÉ À LA PRODUCTION D'UN ÉLÉMENT CONFORME, ÉLÉMENT CONFORME ET UTILISATIONS ASSOCIÉES

(30) Priority: 05.03.2010 FI 20105216
(43) Date of publication of application: 09.01.2013
(73) Proprietor: Canatu Oy, 00390 Helsinki (FI)
(72) Inventor: BROWN, David P., FI-00110 Helsinki (FI)
(74) Representative: Papula Oy
(86) International application number: PCT/FI2011/050196
(87) International publication number: WO 2011/107665

(56) References cited:
- EP-A2- 2 071 631
- WO-A2-03/013199
- WO-A2-2007/149252
- DE-A1-102007 016 995
- US-A1- 2001 040 733
- US-A1- 2004 188 150
- US-A1- 2005 076 824
- US-A1- 2005 126 831
- US-A1- 2006 003 097
- US-A1- 2006 073 089
- US-A1- 2006 274 048
- US-A1- 2006 274 049
- US-A1- 2006 276 056
- US-A1- 2006 276 056

## Description

### FIELD OF THE INVENTION

The invention relates to a method for the production of an at least partially electrically conductive or semi-conductive element on a structure. Further, the invention relates to a conformal and at least partially electrically conductive or semi-conductive element on a structure. Further, the invention relates to uses of a conformal element.

### BACKGROUND OF THE INVENTION

High aspect ratio molecular structures (HARM-structures) are of great interest due to their unique and useful physical and chemical properties. The high conductivity of certain HARM-structures, such as metallic carbon nanotubes, carbon NanoBuds, nanowires and nanoribbons, together with their extremely high aspect ratios allows for efficient electrical percolation, even in randomly oriented surface deposited mats or films. Networks including conducting HARM-structures are useful, for example, as the conductive channel of a transistor. Networks including semi-conducting HARM-structures are useful for example as the semi-conductive channel of a transistor. Such networks have advantages over existing materials such as bulk metals, metal oxides, silicon and inherently conducting polymers in that they can maintain their properties when heated, bent or repeatedly flexed.

Prior art discloses many uses of networks of HARM-structures.

EP 2 071 631 A2 discloses an electronic element including a substrate and a transparent conductive layer, which includes carbon nanotubes.

WO 2007/149252 A2 discloses a touchscreen comprising touch side electrode and device side electrode wherein each electrode comprises an insulating substrate and an exposed electrically conductive layer, wherein said exposed electrically conductive layers are adjacent and separated by dielectric spacers, and wherein only one of the exposed electrically conductive layers comprises carbon nanotubes.

US 2001/040733 A1 discloses a transparent touch panel substrate comprising a transparent substrate and deposited thereon a transparent conductive metal oxide film which contains zinc, indium, and tin as metallic elements and is soluble in acids.

US 2005/126831 A1 discloses a wiring harness and a touch sensor incorporating same.

US 2005/076824 A1 discloses resistive touch screens that employ a conductive polymer on both a topsheet and bottom substrate and that can be operated with the use of conventional electronics.

US 2006/276056 A1 discloses nanotube articles having adjustable electrical conductivity and methods of making the same.

US 2004/188150 A1 discloses a touch sensor employing one or more transparent conductors incorporating a random pattern of voids. The touch sensor is manufactured by depositing a layer of a transparent conductor and forming voids in the transparent conductor.

US 2006/274049 A1 discloses an electronically conductive article comprising at least one conductive carbon nanotube layer in contact with at least one conductive layer comprising electronically conductive polymer.

Prior art discloses, for example, a network for shielding elements against electromagnetic interference (WO 2009/000969). Electromagnetic interference (or EMI, also called radio frequency interference or RFI) is a disturbance that affects an electrical circuit due to either electromagnetic conduction or electromagnetic radiation emitted from an external source. The disturbance may interrupt, obstruct, or otherwise degrade or limit the effective performance of the circuit. Drawback of the prior art shield is that it has not been possible to arrange a conformal shield on a structure to be protected, for example, against electromagnetic radiation. Non-conformal EM-shields, such as traditional Faraday Cages, may cause nonuniformities in the shielding performance which may be difficult to take into account when designing the shield. In addition, traditional non-conformal shield-ings, such as metal cages, are expensive to manufacture and integrate, take up significant space and are rigid. The problem with prior art techniques is, in many applications, the difficulty of forming conformal films or elements.

Further, touch sensing devices, e.g. touch screens, are emerging as popular means to interact with electronic devices. Touch screens can be mechanically mated with many different display types, such as cathode ray tubes (CRTs), liquid crystal displays (LCDs), plasma displays, electroluminescent displays, or bi-stable displays used for electronic paper. The function of typical touch screens or other touch sensing devices is based on an optically transparent touch sensitive film comprising one or more conductive layers configured to serve as one or more sensors. The general operating principle of this kind of film is that the touch of a user, by e.g. fingertip or some particular pointer device, changes an electrical property, such as capacitance or resistance, in a specific location of the touch sensitive film. An electrical signal corresponding to the location of the touch can then be read in a controller or signal processing unit, to control the operation of a device connected to, for instance, a display. Prior art discloses different kinds of touch sensitive films to be used in touch sensing devices. However, the problem with prior art techniques is that it has not been possible to produce truly flexible or conformal touch sensitive films.

In general, prior art techniques do not allow producing truly flexible or conformal elements on three-dimensional surfaces.

### PURPOSE OF THE INVENTION

The purpose of the present invention is to reduce the aforementioned technical problems of the prior art by providing a new method for the production of an at least partially electrically conductive or semi-conductive element on a structure, wherein the element comprises one or more layers and wherein at least one layer comprises a network of HARM-structures. Further, the purpose of the present invention is to present a new conformal and at least partially conductive or semi-conductive element on a structure. Further, the purpose of the present invention is to present uses of a conformal element.

### SUMMARY

The method, the element and the uses according to the present invention are characterized by what is presented in the claims.

The method according to the present invention is characterized by what is presented in independent claim 1.

The element according to the present invention is characterized by what is presented in independent claim 13.

The uses according to the present invention are characterized by what is presented in independent claims 20, 21, and 22.

The method according to the present invention for the production of an at least partially electrically conductive or semi-conductive element on a structure, wherein the element comprises one or more layers, comprises the following steps:
a) forming a formable element comprising one or more layers, wherein at least one layer comprises a network of high aspect ratio molecular structures (HARM-structures), wherein the HARM-structures are electrically conductive or semi-conductive, and
b) arranging the formable element in a conformal manner onto a structure by pressing and/or vacuum sealing the formable element on a three-dimensional surface of the structure,
for producing a conformal and at least partially electrically conductive or semi-conductive element comprising one or more layers, wherein at least one layer comprises a network of HARM-structures, on the three-dimensional surface of the structure.

The conformal and at least partially electrically conductive or semi-conductive element on a structure according to the present invention comprises one or more layers, wherein at least one layer comprises a network of high aspect ratio molecular structures (HARM-structures), wherein the HARM-structures are electrically conductive or semi-conductive and wherein the element is conformally arranged onto a three-dimensional surface of the structure.

By an element is meant any element that is conformally arranged on a structure and shapes conformally with the surface of the structure. The element comprises one or more networks of HARM-structures. The element can further comprise one or more additional materials. The element can comprise one or more layers, for example one or more layers of one or more materials.

By a network is meant, for example, a sparse, dense, random, oriented, homogenous and/or patterned network and/or any other similar structure.

By a network of high aspect ratio molecular structures (HARM-structures) is meant any of above structures comprising one or more HARM-structures. Preferably said network comprises a multitude of HARM-structures. The HARM-structures are electrically conductive or semi-conductive. In one embodiment of the present invention part of the HARM-structures are electrically conductive and another part of the HARM-structures are electrically semi-conductive.

By a HARM-structure is meant a nanotube, a carbon nanotube, a fullerene functionalized carbon nanotube, a NanoBud, a boron-nitride nanotube, a nanorod or nanowire including e.g. carbon, phosphorous, boron, nitrogen, silver and/or silicon, a filament and/or any other tube, tubular, rod and/or ribbon and/or any other high aspect ratio molecular structure. The HARM-structure can be in individual or bundled form. The HARM-structures can be oriented, coated, functionalized and/or otherwise modified before and/or after they are for example deposited and/or arranged onto the structure. An example of the fullerene functionalized carbon nanotube is the carbon NanoBud (CNB), which is a molecule having a fullerene molecule covalently bonded to the side of a tubular carbon molecule.

HARM-structures, and especially carbon nanotubes and carbon NanoBuds, can be deposited on a substrate in the form of a mechanically flexible network. Advantageously it is possible to form a thin layer of the HARM-structure network. Such a layer is flexible and formable and can thus be formed and adjusted conformally on a desired surface. Further, due to the properties of the HARM-structures the formed network is electrically conductive or semi-conductive even in the case of a thin deposit. These advantageous features can be put to use in e.g. touch sensitive films.

By a structure is meant any structure that can be used in the method according to the present invention. By a structure is meant for example any structure onto which a formable element comprising one or more networks of HARM-structures can be arranged in a conformal manner.

In one embodiment of the present invention the structure comprises, for example, a structure that is to be shielded against electromagnetic radiation.

In one embodiment of the present invention the structure comprises one or more electrical components.

A structure can comprise, for example, a transistor, an integrated circuit, an antenna, a memory element or device, a transmitter, a logic or memory circuit and/or any other similar structure. A structure can comprise a populated printed circuit board. A structure can comprise a flexible connector in an electronic device. A structure can comprise, for example, a mobile phone or a part thereof, a product package, a sales kiosk or a part thereof, a household appliance, a window, a dashboard or steering wheel, a car body and/or a helmet and/or any similar structure. Further, any other suitable structure can be used.

By a formable element is meant any desired element, which is suitable to be used in the method in accordance with the present invention. A suitable formable element is such that, at the step of arranging the formable element comprising one or more networks of HARM-structures, and possibly one or more additional materials, in a conformal manner onto a structure, it is able to be conformally placed on the structure and shapes conformally with the structure.

A formable element can be an originally flexible, a rigid or deformable element. A formable element can comprise one or more originally flexible, rigid and/or deformable materials. For example, an originally rigid material, for example a rigid polymer substrate, can be included in the formable element and be used in the method in accordance with the present invention when the rigid polymer substrate is able, for example by heating, elastic and/or plastic deformation and/or wet forming, to become flexible and thus can be conformally placed onto the structure.

In one embodiment of the present invention the formable element comprises one or more layers.

The formable element can be formed by any suitable manner. The formation of the formable element can comprise one or more production steps.

In one embodiment of the present invention step a) comprises forming a formable element comprising one or more networks of HARM-structures and one or more additional materials.

In one embodiment of the present invention step a) comprises forming a formable element comprising one or more networks of HARM-structures and one or more of the following: polymer, paper, nitrocellulose, polyvinylidene fluoride (PVDF), polyethylene (PE), polyethylene terephthalate (PET), polyethylene naphthalate (PEN), polycarbonate, acrylic and polytetrafluoroethylene (Teflon). The formable element can further comprise one or more other additional materials.

In one embodiment of the present invention a formable element can be formed such that it comprises one or more networks of HARM-structures deposited on one or more substrates. The formable element can comprise, for example, a predetermined number of networks of HARM-structures deposited onto a predetermined number of substrates on top of each other. In other words a multilayer structure is formed. In one embodiment of the present invention the one or more substrates comprise one or more polymer substrates. For example, in one embodiment of the present invention at least two networks of HARM-structures are arranged onto a substrate, on both sides of the substrate, thus forming the formable element as a multilayer structure.

In one embodiment of the present invention the substrate is in the form of a layer.

In one embodiment of the present invention the formable element, comprising a multilayer structure, is arranged in a conformal manner onto the structure. For example, if the structure is to be shielded against electromagnetic radiation then the structure may comprise a conformal multilayer element, i.e. a shielding element, which more efficiently shields the structure against electromagnetic radiation.

For example, if the structure is a compound curved substrate on which a solar cell, i.e. an element comprising one or more networks of HARM-structures, is conformally attached, then the solar cell may be a conformal multilayer element, in which the one or more networks of HARM-structures serve as all or one of the transparent electrode, the charge-carrier separation layer and the back electrode, which essentially conformally follows the curvature of the compound curved substrate.

The formable element comprising one or more networks of HARM-structures can comprise an electrostatic dissipation layer (ESD), an electrode in a battery, supercapacitor, fuel cell, touch sensor, haptic interface, display or solar cell, a charge carrier separation layer in a solar cell, a charge carrier recombination layer in a display, a field emission layer in a display, a charge carrier (e.g. ion, electron or hole) transport layer in a touch screen, haptic interface, display or solar cell and/or a source, drain or gate electrode and/or semi-conducting layer in a transistor or IC.

In one embodiment of the present invention one or more networks of HARM-structures are formed by depositing. In one embodiment of the present invention one or more networks of HARM-structures are formed by depositing from a gas flow.

In one embodiment of the present invention one or more networks of HARM-structures are formed by dispersing in a matrix material.

In one embodiment of the present invention step a) comprises depositing HARM-structures onto one or more substrates. Thus one or more networks of HARM-structures can be formed on one or more substrates. In one embodiment of the present invention step a) comprises depositing HARM-structures by filtering HARM-structures from a gas flow.

In one embodiment of the present invention step a) comprises forming a formable element comprising one or more patterned networks of HARM-structures.

In one embodiment of the present invention step a) comprises depositing HARM-structures in a pattern. In this way a patterned network of HARM-structures is formed.

In one embodiment of the present invention step a) comprises depositing HARM-structures onto one or more preliminary substrates and arranging, for example transferring, one or more networks of deposited HARM-structures from the one or more preliminary substrates to the one or more substrates to be used in the formable element. The one or more networks of HARM-structures can be transferred to form a pattern on the one or more substrates. In one embodiment of the present invention step a) comprises depositing HARM-structures by filtering HARM-structures from a gas flow onto a filter material, i.e. preliminary substrate, and transferring the deposited HARM-structures from the filter material to the substrate.

By a preliminary substrate is meant any desired substrate, which is suitable to be used in the method in accordance with the present invention. A preliminary substrate can comprise a flexible, a formable, a rigid or a deformable substrate. The preliminary substrate can comprise, for example polymer, paper, nitrocellulose, polyvinylidene fluoride (PVDF), polyethylene (PE), polyethylene terephthalate (PET), polyethylene naphthalate (PEN), polycarbonate, acrylic and/or polytetrafluoroethylene (Teflon).

By a substrate is meant any desired substrate, which is suitable to be used in the method in accordance with the present invention. A substrate can comprise an originally flexible, formable, rigid or deformable substrate. The substrate can comprise, for example, polymer, paper, nitrocellulose, polyvinylidene fluoride (PVDF), polyethylene (PE), polyethylene terephthalate (PET), polyethylene naphthalate (PEN), polycarbonate, acrylic and/or polytetrafluoroethylene (Teflon). In one embodiment of the present invention the substrate comprises polymer.

In one embodiment of the present invention, a collection filter acts as a preliminary substrate. In one embodiment of the present invention, a collection filter acts as a substrate.

In one embodiment of the present invention the step a) comprises diffusional, magnetic, mechanical, convective, thermophoretic, photophoretic, electrophoretic, gravitational, acoustical, viscous and/or inertial transport of HARM-structures. Other mechanisms are also possible according to the invention. These can be combined to include, for example, inertial impaction, gravitational settling and acoustic focusing. For example, the deposition of HARM-structures onto a substrate and/or onto a preliminary substrate can be performed for example by diffusional, magnetic, mechanical, thermophoretic, photophoretic, electrophoretic, gravitational, acoustical, viscous and/or inertial transport. Further, the arranging of one or more networks of HARM-structures, deposited onto one or more preliminary substrates, from the one or more preliminary substrates onto the one or more substrates can be performed by transfer due to a difference in surface adhesion forces or by diffusional, magnetic, mechanical, thermophoretic, photophoretic, electrophoretic, gravitational, acoustical, viscous and/or inertial transport.

In one embodiment of the present invention the step a) comprises spraying, spin coating, gravure, flexographic, offset, inkjet or other liquid printing of a solution of HARM-structures onto a substrate.

In the present invention step b) of arranging the formable element in a conformal manner onto a structure comprises pressing and/or vacuum sealing said formable element on the structure. I.e. the formable element is arranged onto the surface of the structure by thermoforming.

In one embodiment of the present invention the step of pressing comprises hot pressing.

In one embodiment of the present invention the step of pressing comprises thermo-compression. Thermo-compression comprises physical compression and heating. Physical compression can be performed via an elastic or rigid stamp. In the case of a rigid stamp, the stamp essentially conforms to the shape of the structure.

In the one embodiment of the present invention where vacuum sealing is used a vacuum is created between the formable element and the conformal surface of the structure whereby the formable structure will become conformally attached to the structure.

In one embodiment of the present invention the method can further comprise the step of removing one or more materials from the formable element. For example one or more layers can be removed. This can be done before, during and/or after the step of arranging the formable element in a conformal manner onto the structure. Preferable one or more layers, for example substrates, are removed after the arranging of the formable element onto the structure.

In one embodiment of the present invention steps a) to b) are repeated in parallel and/or in series. The method according to the present invention can be performed as a batch, step-batch and/or continuous process.

In one embodiment of the present invention the element arranged conformally on the structure comprises one or more at least partially electrically conductive or semi-conductive networks of HARM-structures.

In one embodiment of the present invention the element arranged conformally on the structure comprises one or more at least partially electrically or semi-conductive networks of HARM-structures for shielding against electromagnetic radiation.

In one embodiment of the present invention step b) comprises arranging the formable element comprising one or more networks of HARM-structures in a conformal manner onto a structure to be shielded against electromagnetic radiation.

In one embodiment of the present invention the method comprises forming a formable element, comprising one or more networks of HARM-structures, as all or part of a display, solar cell, a touch sensor, a touch screen, a haptic interface and/or thermoacoustic speaker to be conformally placed on a structure, for example, a compound surface.

In one embodiment of the present invention the element is formed as all or part of a display, solar cell, a touch sensor, a touch screen, a haptic interface and/or thermoacoustic speaker conformally placed on a structure, for example, a compound surface.

The network of HARM-structures may be contacted or connected to all or part of the formable element and/or the conformally covered structure. In the case of EM-shield, at least part of the conformally covered structure may also be part of an EMI shield or Faraday cage.

The conformal and at least partially electrically conductive or semi-conductive element on a structure according to the present invention comprises one or more layers, wherein at least one layer comprises a network of HARM-structures.

In the present invention the element is configured to serve as a touch and/or proximity sensitive film.

By a touch and/or a proximity sensitive film is meant a film which can be used as a touch and/or proximity sensitive element in a touch and/or proximity sensing device. In operation, when a touch and/or proximity sensitive film is connected as a part of a suitably configured electrical measurement circuitry of a touch and/or proximity sensing device, a touch of an object on the film, or the presence of an object (e.g. a finger, stylus, pointer or other object) in the proximity of the film, causes a change in one or more properties of the associated circuitry, based on which the touch and/or proximity can be detected and preferably also its location on or near the touch and/or proximity sensitive film determined. In practice, this change is detected by supplying an excitation signal to, and receiving a response signal from the touch and/or proximity sensitive film, and monitoring the changes of the latter.

In one embodiment of the present invention the element configured to serve as a touch and/or proximity sensitive film is optically transparent. By the expression "transparent" is meant essentially transparent for visible light, preferably transmitting more than 50 %, more preferably more than 80 % and most preferably more than 90 % of visible light. It will however be obvious for a skilled person that "transparent" layers transmitting even less than 50 % of visible light can also be used, without departing from the scope of the invention.

In one embodiment of the present invention the element comprises at least one layer comprising a HARMS-network, wherein the HARM-structures are electrically conductive. I.e. the element comprises at least one electrically conductive layer. In the operation of the touch and/or proximity sensitive film as a part of a touch and/or proximity sensing device, the excitation signals can be supplied to and the response signals can be measured from one or more conductive layers.

In one embodiment of the present invention the touch and/or proximity sensitive film comprises one or more sensing regions.

By a sensing region within a touch and/or proximity sensitive film is meant the "active" or operating portion of the touch and/or proximity sensitive film, i.e. the region within which the actual touch and/or proximity sensing operation is to be performed. The touch sensing region can also cover the entire area of the touch and/or proximity sensitive film.

In one embodiment of the present invention the touch and/or proximity sensitive film comprises at least two sensing regions. In one embodiment of the present invention at least one sensing region is configured to serve as a part of a touch screen. In one embodiment of the present invention at least one sensing region is configured to serve as a switch or a button. In one embodiment of the present invention at least one sensing region is configured to serve as a part of touch screen and at least one other sensing region is configured to serve as a switch or a button. I.e. a sensing region can be configured to replace a mechanical button or switch present e.g. in a prior art mobile phone.

In one embodiment of the present invention the touch and/or proximity sensitive film is configured to provide haptic feedback. In one embodiment of the present invention the touch and/or proximity sensitive film and specifically the layer comprising a network of HARM-structures, i.e. a conductive layer, is configured to provide haptic feedback. The layer comprising a network of HARM-structures has electrical properties, such as conductivity, in a range suitable for both touch sensing, such as resistive, capacitive and/or inductive touch sensing, and haptic feedback, such as capacitive or electroactive polymer based haptic feedback. In one embodiment of the present invention the electrical conductivity is between 1 ohm/sq to 100 M ohm/sq, preferably between 100 ohm/sq and 1 M ohm/sq, more preferably between 1 k ohm/sq and 100 k ohm/sq and most preferably approximately 10 k ohm/sq. This feature of the touch and/or proximity sensitive film can provide properties to the touch and/or proximity sensitive film, which creates feedback sensation to the object when small electrical fields pass close the skin for example. The function of the layer is switched between the sensing and haptic feedback function by multiplexing between these two such that, at a first period of time the touch of an object, for instance, a finger, is monitored and at a second period of time the layer is driven to provide a haptic sensation to the same object. In one embodiment of the present invention the first period of time precedes the second period of time. In one embodiment of the present invention the first period of time precedes and/or follows the second period of time.

The term "haptic" refers to touch or tactile sensation. To enhance the user's interaction with the touch sensing device, the touch and/or proximity sensitive film can be configured to provide feedback sensation at a contact location of a surface in response to contact of a user at that location. Feedback sensation can be provided through visual, auditory, kinesthetic, and/or tactile cues. Kinesthetic feedback, such as active and resistive force feedback, and tactile feedback, such as vibration, texture, heat or other physical sensation, is collectively referred to as haptic feedback. In one embodiment of the present invention haptic feedback is capacitive haptic feedback. In one embodiment of the present invention haptic feedback is electroactive polymer based haptic feedback.

In the present invention the touch and/or proximity sensitive film is a capacitive touch and/or proximity sensitive film. In one embodiment the touch and/or proximity sensitive film is a resistive touch and/or proximity sensitive film.

In one embodiment of the present invention the structure is selected from a group consisting of a casing, a display, a display component, a transistor, an integrated circuit, an antenna, a photovoltaic device, a memory element, memory device, a transmitter, a populated printed circuit board, a flexible connector in an electronic device, a display or light source, a thermoacoustic or other speaker, a mobile phone, a computer, a product package, a household appliance, a window, a dashboard, a steering wheel, a car body, a helmet, a visor, parts thereof and combinations thereof. The display component can be a backplane or a frontplane.

In one embodiment of the present invention the element is configured to serve as a shield against electromagnetic radiation.

Further, the invention relates to the use of a conformal and at least partially electrically conductive or semi-conductive element comprising one or more networks of HARM-structures on a structure produced by the method in accordance with the present invention.

Further, the invention relates to the use of a conformal and at least partially electrically conductive or semi-conductive element comprising one or more networks of HARM-structures on a structure.

Further, the invention relates to the use of a conformal and at least partially electrically conductive or semi-conductive element according to the present invention for shielding the structure against electromagnetic radiation.

Further, the invention relates to the use of a conformal and at least partially electrically conductive or semi-conductive element according to the present invention as all or part of an electromagnetic interference shield (EMI-shield or EMS) or a Faraday Cage.

Further the invention relates to the use of a conformal and at least partially electrically conductive or semi-conductive element according to the present invention as an electrostatic dissipation layer (ESD), an electrode in a battery, supercapacitor, fuel cell, touch sensor, haptic interface, thermoacoustic speaker, display or solar cell, a charge carrier separation layer in a solar cell, a charge carrier recombination layer in a display, a field emission layer in a display, a charge carrier (e.g. electron or hole) transport layer in a touch screen, haptic interface, display (e.g. an OLED display) or solar cell and/or a source, drain and/or gate electrode and/or conductive and/or semi-conducting layer in a transistor, backplane or IC.

Further, the invention relates to the use of a conformal and at least partially electrically conductive or semi-conductive element according to the present invention as a touch and/or proximity sensitive film configured to provide haptic feedback.

Further, the invention relates to the use of a single conformal and at least partially electrically conductive or semi-conductive element according to the present invention as both an element of a touch sensor and an element of a haptic interface.

The method according to the present invention is beneficial to both industry and commerce. There are numerous uses for the method according to the present invention where networks of HARM-structures are arranged conformally over a complex structure. These can include elements of displays (such as backlights, backplanes, light emitting layers, field emission layers, charge carrier transport layers and transparent conductor layers), solar cells (such as transparent and opaque conducting layers, light absorption layers, charge carrier separation layers and charge carrier transport layers), conduction and semi-conducting layer of touch sensors and haptic interfaces, electromagnetic shields, anti-static layers, thermoacoustic speaker layers, resistive layers, sensor layers and thin film integrated circuit layers. Products or devices where such conformality is useful include, for instance, compound surfaces of dashboards and car bodies, white goods such as kitchen appliances, medical devices, sales and information kiosks, printed circuit boards including chips, and consumer electronics such as mobile phones, tablets and personal computers.

In general the method in accordance with the invention allows elements such as displays, solar cells, batteries, fuel cells, EMS shields, touch sensors, haptic interfaces, Faraday Cages and super-capasitors to be conformally attached to geometrically complex structures. A particular advantage of the present invention is that it provides a method for producing a conformal electrically conductive or semi-conductive element for shielding components against electromagnetic radiation. The conformality of the shield enables good control of the shielding effect over the entire area of the shield. Additionally, when the conformal element comprises a network of HARM-structures a high conductivity can be achieved even with thin networks. This enables efficient shielding even with thin networks of HARM-structures. Conformality of the shield also facilitates further treatment and processing of the product. Also the production and the integration in a production line are cheaper and easier. Further, it removes design limitations, for instance, in the case of EMS, by allowing mechanical flexibility. Furthermore, patterning of the formable element allows shielding of individual components separated in space on, for example, a PCB. Further, the invention provides a new type of an at least partially electrically conductive or semi-conductive element to be used as a conformal touch and/or proximity sensitive film in a touch and/or proximity sensing device.

The advantage of the present invention relies on e.g. the properties of the formable element comprising at least one layer of a HARMS-network. As discussed above a layer of HARMS-network is flexible and formable enabling the formable element to be conformally arranged by e.g. thermoforming onto a three-dimensional surface. The three-dimensionality of e.g. the touch and/or proximity sensitive film broadens the scope of applications where to implement touch and/or proximity based functions.

### BRIEF DESCRIPTION OF THE DRAWINGS

In the following section, the invention will be described in detail by means of embodiment examples with reference to accompanying drawings, in which
Figure 1 illustrates one embodiment of the present method;
Figure 2 illustrates depositing of HARM-structures according to one embodiment of the present invention;
Figure 3 illustrates a formable element as a multilayer structure according to one embodiment of the present invention;
Figure 4 illustrates a structure having thereon arranged a conformal element according to one embodiment of the present invention;
Figure 5 illustrates a patterned network of deposited HARM-structures on a substrate;
Figure 6 illustrates a way of producing a conformal element configured to serve as a touch sensitive film on a structure according to one embodiment of the present invention;
Figure 7 illustrates an element according to one embodiment of the present invention; and
Figure 8 illustrates one example of a vacuum sealing device.

### DETAILED DESCRIPTION OF THE INVENTION

Reference will now be made in detail to the embodiments of the present invention, examples of which are illustrated in the accompanying drawings.

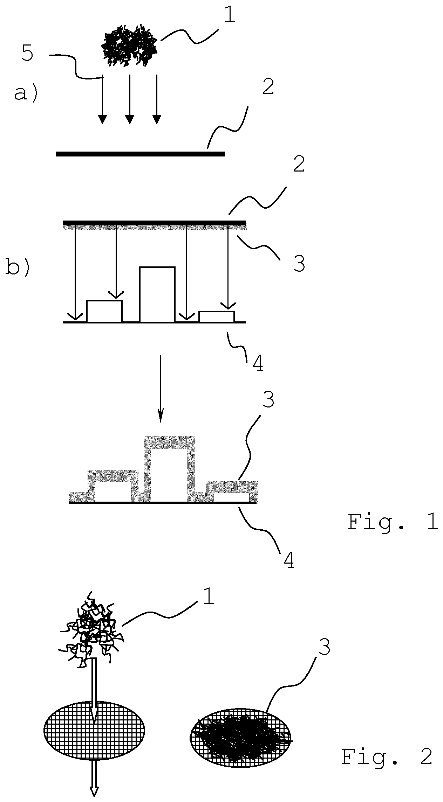

Figure 1 illustrates a schematic representation of one embodiment of the present method for the production of an at least partially electrically conductive element on a structure for shielding the structure against electromagnetic radiation.

In step a) a number of electrically conductive HARM-structures 1, for example in an aerosol, are deposited on a formable substrate 2 by filtering said HARM-structures 1 from a gas flow 5 onto the substrate 2. The deposited HARM-structures form a network of HARM-structures on the substrate. In step b) said network of HARM-structures 3 deposited onto the formable substrate 2, thus forming a formable element, is pressed in a conformal manner onto a structure 4. In the case of EMS, the structure may comprise electrical components. It may also be simply a structure onto which the formable element comprising a network of HARM-structures on a substrate is to be conformally attached. Finally the substrate 2 is removed. In this way a conformal element comprising a network of HARM-structures is produced on a structure.

It is also possible to deposit a network of HARM-structures onto a preliminary substrate, for example a filter, and then transfer said network of HARM-structures from the filter to a formable substrate comprising for example PET (polyethylene terephthalate) and finally conformally compress the formable element comprising the network of HARM-structures on the PET substrate onto the structure.

Figure 2 illustrates a schematic representation of one embodiment of the present method for obtaining a network of HARM-structures 3 on a substrate. HARM-structures 1 are made to pass through a filter so that a network of HARM-structures 3 is formed on the filter.

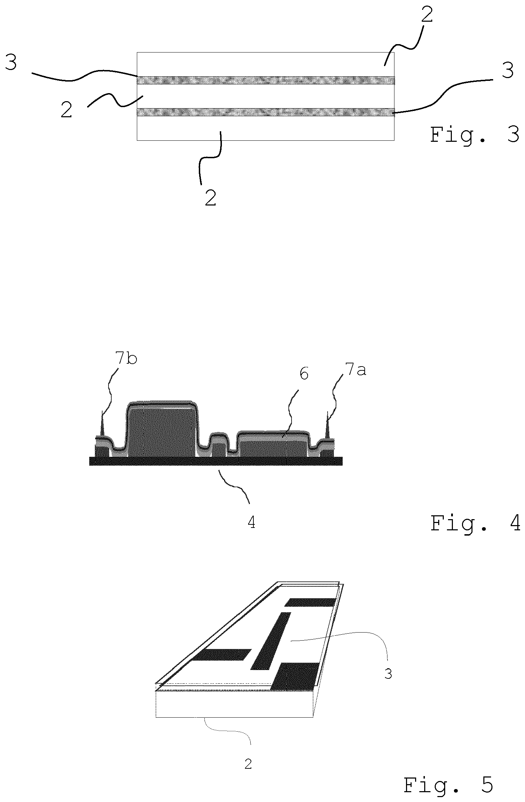

Figure 3 illustrates a formable element comprising a multilayer structure according to one embodiment of the present invention. In this example two networks of HARM-structures 3 are arranged or sandwiched between three formable substrates 2. The substrates can comprise for example polymer and the networks of HARM-structures can comprise for example carbon nanotubes.

Figure 4 illustrates a structure onto which a formable element has been arranged in a conformal manner. The conformal element 6 arranged on the structure 4 comprising electrical components, for example, by thermophoretic compression, can, for example, act as an EM-shield. Further, Figure 4 illustrates the use of connecting pins 7a,7b to, for example, complete a Faraday cage.

Figure 5 illustrates a patterned network of deposited HARM-structures 3 on a substrate 2. The HARM-structures deposited are illustrated by black rectangular in the figure. The HARM-structures have been deposited on substrate as a pattern corresponding to the function in the application, where it is to be used. Thus a substrate having thereon deposited a patterned network of HARM-structures, the pattern corresponding to the regions of the structure to be, for example, shielded, can be used to shield those portions of the structure. Patterning of the formable element thus allows shielding of individual components separated in space on, for example, a PCB.

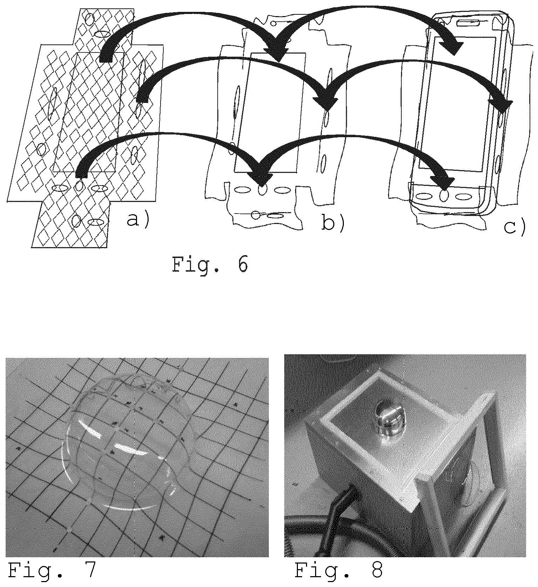

Figure 6 illustrates one example of producing a conformal and at least partially electrically conductive or semi-conductive element on a structure. Step a) comprises forming a formable element in the form of a multilayered structure. The multilayer structure can be formed e.g. as discussed above such that a patterned or unpatterned network of HARM-structures is formed on e.g. a polymer substrate layer. The multilayer structure comprises at least one thin layer of a network of HARM-structures. The essential feature is the flexibility and formability of the formed multilayered structure or film comprising HARM-structures. Step b) comprises thermoforming, e.g. using thermocompression or vacuum sealing, the formable element conformally onto a three-dimensional surface of a structure. Also other means for conformally covering the surface of the structure are possible according to the present invention. In this exemplary embodiment the formable element is arranged conformally over a display and phone casing. The element conformally arranged onto the structure is in this embodiment configured to serve as a touch sensitive film. Based on the properties of the layer comprising a HARM-network, the touch sensitive film can also provide haptic feedback. Further, as can be seen from step c) of Fig. 6 the multilayered element formed onto the structure, in this case on at least a part of a mobile phone, also replaces the function of any mechanical buttons or switches used in prior art mobile phones. In addition to the technically improved functions achieved with the present invention, advantageously, the use of the new conformal and electrically conductive element on a structure will also simplify and ameliorate the appearance of e.g. mobile phones.

Figure 7 illustrates an element that has been arranged in a conformal manner using vacuum sealing according to one embodiment of the present invention. In this embodiment a sheet or layer of HARM-structures on a 1.5 mm PET-G substrate was placed on a frame and heated in an oven to 150 °C for 3.5 minutes such that the substrate was sagging in the frame. The frame and the sheet were placed over a suction box (an example of which is presented in Figure 8) such that a seal was created between the sheet and a sealing element, by gas being drawn through the suction surface, and a vacuum was created such that the formable element was drawn over the mold so as to conform to the mold surface.

### Example 1

As an example of how to deposit a network of HARM-structures onto the formable substrate, thus forming an formable element, according to one embodiment of the present invention, SWCNTs (single walled carbon nanotubes) were synthesized in an aerosol laminar flow (floating catalyst) reactor using carbon monoxide and ferrocene as a carbon source and a catalyst precursor, respectively.

SWCNTs were then collected directly from the gas phase downstream of the reactor by filtering through a 2.45 cm diameter nitrocellulose (or silver) disk filter (Millipore Corp, USA). The filter, in this embodiment, takes the role of a formable substrate. The deposition temperature on the filter surface was measured to be 45 °C. The layer thickness of SWCNT networks formed on the substrate was controlled by the deposition time, which could be altered from a few seconds to several hours depending on the desired network thickness. Measurement results showed that the deposits were randomly oriented networks of SWCNTs.

Physical compression and heating (thermo-compression) was used to arrange the above formed networks of SWCNTs in a conformal manner from the substrate onto the structure. Thermo-compression was carried out by first softening the substrate by soaking in water, then applying a force between two parallel heated plates between which the substrate and the structure were placed, such that the network of SWCNTs was sandwiched in between the substrate and the structure. The heated compression plates naturally also caused heating of the deposition substrate, the SWCNT-network and the structure to be shielded. In one example, after thermo-compression the substrate was removed from contact with the network of SWCNTs.

### Example 2

In accordance with the present invention a structure, for example, to be shielded against electromagnetic radiation can comprise an element comprising a multilayer structure arranged in a conformal manner onto said structure. The multilayer structure can comprise a number of networks of HARM-structures sandwiched between, for example, a number of polymer substrates, to enhance the shielding compared to a single network of HARM-structures. Said multilayer element can for example comprise a second network of HARM-structures on top of a first polymer substrate having thereon arranged a first network of HARM-structures on the other side against the structure to be shielded. This multilayer element comprises thus a first network of HARM-structures on one side of the first polymer substrate and the second network of HARM-structures on the other side of the first polymer substrate. On the second network of HARM-structures can further be a second polymer substrate, in which case the second network is sandwiched between the first and the second polymer substrates.

Thermo-compression was employed to form the formable element comprising the multilayer structure with one or more networks of HARM-structures sandwiched between two or more polymer substrates. After forming the multilayer structure the multilayer structure was pressed in a conformal manner onto the structure to be shielded, again using thermo-compression. This thermo-compression step was carried out by applying a force between two parallel heated plates between which the multilayer structure and the structure to be shielded were placed such that the multilayer structure was sandwiched in between a parallel plate and the structure to be shielded. The heated compression plates naturally also caused heating of the structure to be shielded.

### Example 3

A thermoacoustic speaker is manufactured, in which a conductive network of HARM-structures on a PET substrate is thermocompressed over a compound curved glass surface. Electrodes are attached and the speaker is attached to an output jack of an amplifier to drive the speaker.

### Example 4

In accordance with the present invention a structure, for example, a solar cell can be manufactured according to the method outlined in FI 20075767, in which a conductive network of HARM-structures, i.e. a HARM-film on a PET substrate is incorporated as the transparent electrode layer and/or as the charge-carrier separation layer and/or as the charge-carrier layer. The solar cell, i.e. the formable element, is then thermocompressed over a compound curved glass surface.

### Example 5

In accordance with the present invention a structure, for example, an electrophoretic display with an integrated touch screen can be manufactured according to the method outlined in FI 20095911 in which a conductive HARM film on a PET substrate is incorporated as one or more transparent electrode layers and/or as the gate layer in the back plane and/or as the semi-conducting layer in the backplane. The formable element is then thermocompressed over a compound curved plastic surface.

### Example 6

In accordance with the present invention a structure, for example, a mobile phone with an integrated combined touch sensing surface and haptic interface or feedback surface is manufactured. The element configured to serve as both a touch sensitive film and a haptic interface or feedback surface was fabricated by forming a conductive HARM-layer on a PET substrate, i.e. forming a formable element, and by conformally arranging this onto the structure by vacuum sealing. In this example the formable element was heated and then vacuum was drawn such that the formable element conformed over the shape of the phone. A portion of the conformally arranged element covered the display area to serve as a combined touch screen and haptic interface and another portion of the conformally arranged element covered the casing to serve as a combined touch surface and haptic interface. The electrical conductivity of the element configured to serve as a combined touch sensitive film and haptic interface film was in the range between 1 ohm/sq to 100 M ohm/sq, preferably between 100 ohm/sq and 1 M ohm/sq, more preferably between 1 k ohm/sq and 100 k ohm/sq and most preferably approximately 10 k ohm/sq. This film having the above electrical conductivity is suitable for both touch and/or proximity sensing and haptic feedback, such as capacitive haptic feedback or electroactive polymer feedback. The film was then connected to an appropriate touch circuit or circuits and/or to an appropriate haptic circuit or circuits. The circuit driving and/or monitoring film is switched between the touch sensing and haptic feedback functions by multiplexing between these two such that, at a first period of time the touch of an object, for instance, a finger, is monitored and at a different second period of time the film is driven to provide a haptic sensation to the same object.

It is obvious to a person skilled in the art that with the advancement of technology, the basic idea of the invention may be implemented in various ways. The invention and its embodiments are thus not limited to the examples described above; instead they may vary within the scope of the claims.

## Claims

1. A method for the production of an at least partially electrically conductive or semi-conductive element on a structure, wherein the element comprises one or more layers and is configured to serve as a capacitive touch and/or proximity sensitive film, **characterized in that** the method comprises the steps of
a) forming a formable element comprising one or more layers, wherein at least one layer comprises a network of high aspect ratio molecular structures (HARM-structures), wherein the HARM-structures are electrically conductive or semi-conductive, and
b) arranging the formable element in a conformal manner onto a structure by pressing and/or vacuum sealing the formable element on a three-dimensional surface of the structure,
for producing a conformal and at least partially electrically conductive or semi-conductive element comprising one or more layers, wherein at least one layer comprises a network of HARM-structures, on the three-dimensional surface of the structure.

2. The method according to claim 1, **characterized in that** step a) comprises forming a formable element comprising one or more networks of HARM-structures and one or more additional materials.

3. The method according to any of preceding claims 1 - 2, **characterized in that** step a) comprises forming a formable element comprising one or more networks of HARM-structures and one or more of the following: polymer, paper, nitrocellulose, polyvinylidene fluoride (PVDF), polyethylene (PE), polyethylene terephthalate (PET), polyethylene naphthalate (PEN), polycarbonate, acrylic and polytetrafluoroethylene (Teflon).

4. The method according to any of preceding claims 1 - 3, **characterized in that** one or more networks of HARM-structures are formed by depositing from a gas flow.

5. The method according to any of preceding claims 1 - 4, **characterized in that** step a) comprises depositing HARM-structures onto one or more substrates.

6. The method according to any of preceding claims 1 - 5, **characterized in that** step a) comprises depositing HARM-structures onto one or more preliminary substrates and arranging one or more networks of deposited HARM-structures from the one or more preliminary substrates to the one or more substrates.

7. The method according to any of preceding claims 1 - 6, **characterized in that** step a) comprises diffusional, magnetic, mechanical, convective, thermophoretic, photophoretic, electrophoretic, gravitational, acoustical, viscous and/or inertial transport of HARM-structures.

8. The method according to any of preceding claims 1 - 7, **characterized in that** the step of pressing comprises thermo-compression.

9. The method according to any of preceding claims 1 - 8, **characterized in that** the structure comprises one or more electrical components.

10. The method according to any of preceding claims 1 - 9, **characterized in that** the HARM-structure comprises a nanotube, a carbon nanotube, a fullerene functionalized carbon nanotube, a nanobud, a boron-nitride nanotube, a nanorod or nanowire including carbon, phosphorous, boron, nitrogen, silver and/or silicon, a filament and/or any other tube, tubular, rod and/or ribbon and/or any other high aspect ratio molecular structure in individual or bundled form.

11. The method according to any of preceding claims 1 - 10, **characterized in that** the element arranged conformally on the structure comprises one or more at least partially electrically conductive or semi-conductive networks of HARM-structures for shielding against electromagnetic radiation.

12. The method according to any of preceding claims 1 - 11, **characterized in that** step b) comprises arranging the formable element comprising one or more networks of HARM-structures in a conformal manner onto a structure to be shielded against electromagnetic radiation.

13. A conformal and at least partially electrically conductive or semi-conductive element on a structure, wherein the element comprises one or more layers and is configured to serve as a capacitive touch and/or proximity sensitive film, obtainable by the method according to any of preceding claims 1 - 12, **characterized in that** at least one layer comprises a network of high aspect ratio molecular structures (HARM-structures), wherein the HARM-structures are electrically conductive or semi-conductive and wherein the element is conformally arranged onto a three-dimensional surface of the structure.

14. The element according to claim 13, **characterized in that** the touch and/or proximity sensitive film comprises at least two sensing regions.

15. The element according to claim 14, **characterized in that** at least one sensing region is configured to serve as a part of a touch screen.

16. The element according to any of preceding claims 13 - 15, **characterized in that** the touch and/or proximity sensitive film is configured to provide haptic feedback.

17. The element according to any of preceding claims 13 - 16, **characterized in that** the structure is selected from a group consisting of a casing, a display, a display component, a transistor, an integrated circuit, an antenna, a photovoltaic device, a memory element, memory device, a transmitter, a populated printed circuit board, a flexible connector in an electronic device, a display or light source, a thermoacoustic speaker, a mobile phone, a computer, a sales or information kiosk, a product package, a household appliance, a window, a dashboard, a steering wheel, a car body, a helmet, a visor, parts thereof and combinations thereof.

18. The element according to any of preceding claims 13 - 17, **characterized in that** the HARM-structure comprises a nanotube, a carbon nanotube, a fullerene functionalized carbon nanotube, a nanobud, a boron-nitride nanotube, a nanorod or nanowire including carbon, phosphorous, boron, nitrogen, silver and/or silicon, a filament and/or any other tube, tubular, rod and/or ribbon and/or any other high aspect ratio molecular structure in individual or bundled form.

19. The element according to claim 13, **characterized in that** the element is configured to serve as a shield against electromagnetic radiation.

20. The use of a conformal and at least partially electrically conductive or semi-conductive element according to any of preceding claims 13 - 19 for shielding the structure against electromagnetic radiation.

21. The use of a conformal and at least partially electrically conductive or semi-conductive element according to any of preceding claims 13 - 19 as an electrostatic dissipation layer (ESD), an electrode in a battery, supercap, fuel cell, touch sensor, haptic interface, display or solar cell, a charge carrier separation layer in a solar cell, a charge carrier recombination layer in a display, a field emission layer in a display, a charge carrier transport layer in a touch screen, haptic interface, thermoacoustic speaker, display or solar cell and/or a source, drain and/or gate electrode and/or semi-conducting layer in a transistor, backplane or IC.

22. The use of a single conformal and at least partially electrically conductive or semi-conductive element according to any of the preceding claims 13 - 19 as both an element of a touch sensor and an element of a haptic interface.

## Patentansprüche

1. Verfahren für die Produktion eines zumindest teilweise elektrisch leitenden oder halbleitenden Elements auf einer Struktur, wobei das Element eine oder mehrere Schichten aufweist und konfiguriert ist, um als ein kapazitiver Berührungs - und/oder Näherungs-empfindlicher Film zu dienen, **dadurch gekennzeichnet, dass** das Verfahren die folgenden Schritte umfasst:
a) Bilden eines formbaren Elements mit einer oder mehreren Schichten, wobei zumindest eine Schicht ein Netzwerk von molekularen Strukturen mit einem hohen Aspektverhältnis (HARM-Strukturen) aufweist, wobei die HARM-Strukturen elektrisch leitend oder halbleitend sind und
b) Anordnen des formbaren Elements in einer konformen bzw. winkelgetreuen Weise auf eine Struktur durch Drücken und/oder Vakuumabdichten des formbaren Elements auf einer dreidimensionalen Oberfläche der Struktur
zum Produzieren eines winkelgetreuen und zumindest teilweise leitenden oder halbleitenden Elements mit einer oder mehreren Schichten, wobei zumindest eine Schicht ein Netzwerk von HARM-Strukturen auf der dreidimensionalen Oberfläche der Struktur aufweist.

2. Verfahren nach Anspruch 1, **dadurch gekennzeichnet, dass** Schritt a) das Bilden eines formbaren Elements mit einem oder mehreren Netzwerken von HARM-Strukturen und einem oder mehreren zusätzlichen Materialien umfasst.

3. Verfahren nach einem der vorstehenden Ansprüche 1-2, **dadurch gekennzeichnet, dass** Schritt a) das Bilden eines formbaren Elements mit einem oder mehreren Netzwerken von HARM-Strukturen und einem oder mehreren der folgenden umfasst: Polymer, Papier, Nitrozellulose, Polyviniliden-Fluorid (PVDF), Polyethylen (PE), Polyethylen-Terephthalat (PET), Polyethylen-Naphthalat (PEN), Polycarbonat, Akryl- und Polytetrafluorethylen (Teflon).

4. Verfahren nach einem der vorstehenden Ansprüche 1-3, **dadurch gekennzeichnet, dass** ein oder mehrere Netzwerke von HARM-Strukturen durch Auftragen btw. Ablagerung aus einem Gasfluss gebildet werden.

5. Verfahren nach einem der vorstehenden Ansprüche 1-4, **dadurch gekennzeichnet, dass** Schritt a) das Auftragen von HARM-Strukturen auf ein oder mehrere Substrate umfasst.

6. Verfahren nach einem der vorstehenden Ansprüche 1-5, **dadurch gekennzeichnet, dass** Schritt a) das Auftragen von HARM-Strukturen auf ein oder mehrere vorläufige Stubstrate und das Anordnen von einem oder mehreren Netzwerken von aufgetragenen HARM-Strukturen von dem einen oder den mehreren vorläufigen Substraten auf das eine oder die mehreren Substrate umfasst.

7. Verfahren nach einem der vorstehenden Ansprüche 1-6, **dadurch gekennzeichnet, dass** Schritt a) diffusionsfähigen, magnetischen, mechanischen, konvektiven, thermophoretischen, photophoretischen, elektrophoretischen, gravitativen, akustischen, viskosen und/oder inerten Transport von HARM-Strukturen umfasst.

8. Verfahren nach einem der vorstehenden Ansprüche 1-7, **dadurch gekennzeichnet, dass** der Schritt des Drückens Thermokompression umfasst.

9. Verfahren nach einem der vorstehenden Ansprüche 1-9, **dadurch gekennzeichnet, dass** die Struktur eine oder mehrere elektrische Komponenten aufweist.

10. Verfahren nach einem der vorstehenden Ansprüche 1-9, **dadurch gekennzeichnet, dass** die HARM-Struktur eine Nanoröhre, eine Kohlenstoffnanoröhre, eine Fulleren-funktionalisierte Kohlenstoffnanoröhre, eine Nanoknospe, eine BorNitrid-Nanoröhre, ein Nanorohr oder Nanokabel, das Kohlenstoff aufweist, Phosphor, Bor, Stickstoff, Silber und/oder Silizium, ein Filament und/oder irgendeine andere Röhre, röhrenförmige, rohrförmige und/oder Band- und/oder irgendeine andere molekulare Struktur mit einem hohen Aspektverhältnis in individueller oder gebündelter Form aufweist.

11. Verfahren nach einem der vorstehenden Ansprüche 1-10, **dadurch gekennzeichnet, dass** das Element, das winkelgetreu auf der Struktur angeordnet ist, ein oder mehrere zumindest teilweise elektrisch leitende oder halbleitende Netzwerke von HARM-Strukturen zum Abschirmen gegen elektromagnetische Strahlung aufweist.

12. Verfahren nach einem der vorstehenden Ansprüche 1-11, **dadurch gekennzeichnet, dass** Schritt b) das Anordnen des formbaren Elements mit einem oder mehreren Netzwerken von HARM-Strukturen in einer winkelgetreuen Weise auf eine Struktur, die gegen elektromagnetische Strahlung abgeschirmt werden soll, umfasst.

13. Winkelgetreues und zumindest teilweise elektrisch leitendes oder halbleitendes Element auf einer Struktur, wobei das Element eine oder mehrere Schichten aufweist, und konfiguriert ist, um als ein kapazitiver Berührungs- und/oder Näherungs-empfindlicher Film zu dienen, das erhaltbar durch das Verfahren nach einem der vorstehenden Ansprüche 1-12 ist, **dadurch gekennzeichnet, dass** zumindest eine Schicht ein Netzwerk von molekularen Strukturen mit einem hohen Aspektverhältnis (HARM-Strukturen) aufweist, wobei die HARM-Strukturen elektrisch leitend oder halbleitend sind und wobei das Element winkelgetreu auf einer dreidimensionalen Oberfläche der Struktur angeordnet ist.

14. Element nach Anspruch 13, **dadurch gekennzeichnet, dass** der Berührungs- und/oder Näherungs-empfindliche Film zumindest zwei Erfassungsbereiche aufweist.

15. Element nach Anspruch 14, **dadurch gekennzeichnet, dass** zumindest ein Erfassungsbereich konfiguriert ist, um als ein Teil eines Touch-Screens zu dienen.

16. Element nach einem der vorstehenden Ansprüche 13-15, **dadurch gekennzeichnet, dass** der Berührungs- und/oder Näherungs-empfindliche Film konfiguriert ist, um eine haptische Rückmeldung bereitzustellen.

17. Element nach einem der vorstehenden Ansprüche 13-16, **dadurch gekennzeichnet, dass** die Struktur aus einer Gruppe ausgewählt ist, die aus einer Hülle, einer Anzeige, einer Anzeigenkomponente, einem Transistor, einem integrierten Schaltkreis, einer Antenne, einer Photovoltaik-Vorrichtung, einem Speicherelement, einer Speichervorrichutng, einem Transmitter, einer bestückten Leiterplatte, einem flexiblen Verbindungsglied in einer elektronischen Vorrichtung, einer Anzeige oder Lichtquelle, einem thermoakustischen Lautsprecher, einem Mobiltelephon, einem Computer, einem Verkaufs- oder Informationskiosk, einer Produktpaket, einem Haushaltsgerät, einem Fenster, einem Armaturenbrett, einem Lenkrad, einem Autokörper, einem Helm, einem Visier, Teilen davon und Kombinationen davon besteht.

18. Element nach einem der vorstehenden Ansprüche 13-17, **dadurch gekennzeichnet, dass** die HARM-Struktur eine Nanoröhre, eine Kohlenstoffnanoröhre, eine Fulleren-funktionalisierte Kohlenstoffnanoröhre, eine Nanoknospe, eine BorNitrid-Nanoröhre, ein Nanorohr oder Nanokabel, das Kohlenstoff aufweist, Phophor, Bor, Stuckstoff, Silber und/oder Silizium, ein Filament und/oder irgend eine andere Röhre, röhrenförmige, rohrförmige und/oder Band- und/oder andere molekulare Struktur mit einem hohen Aspektverhältnis in individueller oder gebündelter Form aufweist.

19. Element nach Anspruch 13, **dadurch gekennzeichnet, dass** das Element konfiguriert ist, um als eine Abschirmung gegen elektromagnetische Strahlung zu dienen.

20. Verwendung von einem winkelförmigen und zumindest teilweise elektrisch leitenden oder halbleitenden Element nach einem der vorstehenden Ansprüche 13-19 zum Abschirmen der Struktur gegen elektromagnetische Strahlung.

21. Verwendung von einem winkelgetreuen und zumindest teilweise elektrisch leitenden oder halbleitenden Element nach einem der vorstehenden Ansprüche 13-19 als eine elektrostatische Dissipationsschicht (ESD), eine Elektrode in einer Batterie, ein Supercap, eine Brennstoffzelle, ein Berührungssensor, eine haptische Schnittstelle, eine Anzeige oder eine Solarzelle, einer Ladungsträgertrennungsschicht in einer Solarzelle, eine Ladungsträger-Rekombinationsschicht in einer Anzeige, eine Feldemissionsschicht in einer Anzeige, einer Ladungsträgertransportschicht in einem Touch-Screen, eine haptische Schnittstelle, ein thermoakustischer Lautsprecher, eine Anzeige oder Solarzelle und/oder eine Source-, Drain- und/oder Gate-Elektrode und/oder eine halbleitende Schicht in einem Transistor, eine Verdrahtungsplatte oder IC.

22. Verwendung eines einzelnen winkelgetreuen und zumindest teilweise elektrisch leitenden oder halbleitenden Elements nach einem der vorstehenden Ansprüche 13-19 sowohl als ein Element eines Berührungssensors als auch als ein Element einer haptischen Schnittstelle.

## Revendications

1. Procédé pour la production d'un élément au moins partiellement électriquement conducteur ou semi-conducteur sur une structure, dans lequel l'élément comprend une ou plusieurs couches et est configuré pour servir de film capacitif sensible au toucher et/ou à la proximité, **caractérisé en ce que** le procédé comprend les étapes de
a) formation d'un élément pouvant être mis en forme comprenant une ou plusieurs couches, dans lequel au moins une couche comprend un réseau de structures moléculaires à rapport largeur/longueur élevé (structures HARM), dans lequel les structures HARM sont électriquement conductrices ou semi-conductrices, et
b) agencement de l'élément pouvant être mis en forme d'une manière conforme sur une structure en pressant et/ou scellant sous vide l'élément pouvant être mis en forme sur une surface tridimensionnelle de la structure,
pour produire un élément conforme et au moins partiellement électriquement conducteur ou semi-conducteur comprenant une ou plusieurs couches, dans lequel au moins une couche comprend un réseau de structures HARM, sur la surface tridimensionnelle de la structure.

2. Procédé selon la revendication 1, **caractérisé en ce que** l'étape a) comprend la mise en forme d'un élément pouvant être mis en forme comprenant un ou plusieurs réseaux de structures HARM et un ou plusieurs matériaux supplémentaires.

3. Procédé selon l'une quelconque des revendications précédentes 1-2, **caractérisé en ce que** l'étape a) comprend la mise en forme d'un élément pouvant être mis en forme comprenant un ou plusieurs réseaux de structures HARM et un ou plusieurs de ce qui suit : polymère, papier, nitrocellulose, polyfluorure de vinylidène (PVDF), polyéthylène (PE), polyéthylène téréphtalate (PET), polyéthylène naphtalate (PEN), polycarbonate, acrylique et polytétrafluoroéthylène (Téflon).

4. Procédé selon l'une quelconque des revendications précédentes 1-3, **caractérisé en ce qu'**un ou plusieurs réseaux de structures HARM sont mis en forme par dépôt à partir d'un écoulement de gaz.

5. Procédé selon l'une quelconque des revendications précédentes 1-4, **caractérisé en ce que** l'étape a) comprend le dépôt de structures HARM sur un ou plusieurs substrats.

6. Procédé selon l'une quelconque des revendications précédentes 1-5, **caractérisé en ce que** l'étape a) comprend le dépôt de structures HARM sur un ou plusieurs substrats préliminaires et l'agencement d'un ou de plusieurs réseaux de structures HARM déposées à partir des un ou plusieurs substrats préliminaires vers les un ou plusieurs substrats.

7. Procédé selon l'une quelconque des revendications précédentes 1-6, **caractérisé en ce que** l'étape a) comprend le transport par diffusion, magnétique, mécanique, par convection, thermophorétique, photophorétique, électrophorétique, par gravitation, acoustique, visqueux et/ou par inertie de structures HARM.

8. Procédé selon l'une quelconque des revendications précédentes 1-7, **caractérisé en ce que** l'étape de pressage comprend la thermocompression.

9. Procédé selon l'une quelconque des revendications précédentes 1-8, **caractérisé en ce que** la structure comprend un ou plusieurs composants électriques.

10. Procédé selon l'une quelconque des revendications précédentes 1-9, **caractérisé en ce que** la structure HARM comprend un nanotube, un nanotube de carbone, un nanotube de carbone fonctionnalisé par fullerène, un nano-bourgeon, un nanotube de nitrure de bore, une nanotige ou un nanofil incluant du carbone, du phosphore, du bore, de l'azote, de l'argent et/ou du silicium, un filament et/ou tout autre tube, élément tubulaire, tige et/ou ruban et/ou toute autre structure moléculaire à rapport largeur/longueur élevé sous forme individuelle ou regroupée.

11. Procédé selon l'une quelconque des revendications précédentes 1-10, **caractérisé en ce que** l'élément agencé de manière conforme sur la structure comprend un ou plusieurs réseaux au moins partiellement électriquement conducteurs ou semi-conducteurs de structures HARM pour protection contre le rayonnement électromagnétique.

12. Procédé selon l'une quelconque des revendications précédentes 1-11, **caractérisé en ce que** l'étape b) comprend l'agencement de l'élément pouvant être mis en forme comprenant un ou plusieurs réseaux de structures HARM d'une manière conforme sur une structure à protéger contre le rayonnement électromagnétique.

13. Élément conforme et au moins partiellement électriquement conducteur ou semi-conducteur sur une structure, dans lequel l'élément comprend une ou plusieurs couches et est configuré pour servir de film capacitif sensible au toucher et/ou à la proximité, pouvant être obtenu par le procédé selon l'une quelconque des revendications précédentes 1-12, **caractérisé en ce qu'**au moins une couche comprend un réseau de structures moléculaires à rapport largeur/longueur élevé (structures HARM), dans lequel les structures HARM sont électriquement conductrices ou semi-conductrices et dans lequel l'élément est agencé de manière conforme sur une surface tridimensionnelle de la structure.

14. Élément selon la revendication 13, **caractérisé en ce que** le film sensible au toucher et/ou à la proximité comprend au moins deux régions tactiles.

15. Élément selon la revendication 14, **caractérisé en ce qu'**au moins une région tactile est configurée pour servir de partie d'un écran tactile.

16. Élément selon l'une quelconque des revendications précédentes 13-15, **caractérisé en ce que** le film sensible au toucher et/ou à la proximité est configuré pour fournir un retour haptique.

17. Élément selon l'une quelconque des revendications précédentes 13-16, **caractérisé en ce que** la structure est sélectionnée dans un groupe constitué d'un boîtier, d'un dispositif d'affichage, d'un composant d'affichage, d'un transistor, d'un circuit intégré, d'une antenne, d'un dispositif photovoltaïque, d'un élément de mémoire, d'un dispositif de mémoire, d'un émetteur, d'une carte de circuit imprimé équipée, un connecteur flexible dans un dispositif électronique, une source d'affichage ou de lumière, un haut-parleur thermo-acoustique, un téléphone mobile, un ordinateur, un kiosque de vente ou d'informations, un emballage de produit, un appareil ménager, une fenêtre, un tableau de bord, un volant, une carrosserie de voiture, un casque, une visière, des parties de ceux-ci et des combinaisons de ceux-ci.

18. Élément selon l'une quelconque des revendications précédentes 13-17, **caractérisé en ce que** la structure HARM comprend un nanotube, un nanotube de carbone, un nanotube de carbone fonctionnalisé par fullerène, un nano-bourgeon, un nanotube de nitrure de bore, une nanotige ou un nanofil incluant du carbone, du phosphore, du bore, de l'azote, de l'argent et/ou du silicium, un filament et/ou tout autre tube, élément tubulaire, tige et/ou ruban et/ou toute autre structure moléculaire à rapport largeur/longueur élevé sous forme individuelle ou regroupée.

19. Élément selon la revendication 13, **caractérisé en ce que** l'élément est configuré pour servir de protection contre le rayonnement électromagnétique.

20. Utilisation d'un élément conforme et au moins partiellement électriquement conducteur ou semi-conducteur selon l'une quelconque des revendications 13-19 pour protéger la structure contre le rayonnement électromagnétique.

21. Utilisation d'un élément conforme et au moins partiellement électriquement conducteur ou semi-conducteur selon l'une quelconque des revendications 13-19 comme couche de dissipation électrostatique (ESD), électrode dans une batterie, supercondensateur, pile à combustible, capteur tactile, interface haptique, cellule d'affichage ou solaire, couche de séparation de porteur de charge dans une cellule solaire, couche de recombinaison de porteur de charge dans un dispositif d'affichage, couche d'émission de champ dans un dispositif d'affichage, couche de transport de porteur de charge dans un écran tactile, interface haptique, haut-parleur thermo-acoustique, cellule d'affichage ou solaire et/ou électrode de source, de drain et/ou de grille et/ou couche semi-conductrice dans un transistor, fond de panier ou CI.

22. Utilisation d'un unique élément conforme et au moins partiellement électriquement conducteur ou semi-conducteur selon l'une quelconque des revendications 13-19 comme élément d'un capteur tactile et élément d'une interface haptique.
